# EUROPÄISCHE PATENTANMELDUNG

(11) **EP 1 178 520 A2**
(43) Veröffentlichungstag der Anmeldung: **06.02.2002**
(21) Anmeldenummer: 01115992.8
(22) Anmeldetag: 30.06.2001
(51) Int. Cl.: H01L 21/00

(54) **Substratheizung zum gleichzeitig beidseitigen Beheizen eines Wafers**

(30) Priorität: 02.08.2000 DE 10037566
(71) Anmelder: Forschungszentrum Karlsruhe GmbH, 76133 Karlsruhe (DE)
(72) Erfinder: Scheerer, Bernd, 76344 Eggenstein-Leopoldshafen (DE); Reiner, Johann, 76351 Linkenheim-Hochstetten (DE); Geerk, Jochen, Dr., 76356 Weingarten (DE)

(57) **Zusammenfassung**

Eine Substratheizung zum beidseitigen Beschichten eines Wafers ist so gebaut, daß der Wafer simultan beidseitig beschichtet werden kann. Die Heizung besteht aus zwei gleichartigen, wannenförmigen Heizeinrichtungen, die spiegelbildlich zueinander stehen und so einen Heizraum, weitestgehend einen Strahlungshohlraum, bilden, wobei die beiden Heizeinrichtungen soweit auseinander stehen, daß der auf einer Transporteinrichtung sitzende, zu prozessierende Wafer gerade hochkant hindurch gezogen werden kann.

## Beschreibung

Die Erfindung betrifft eine Substratheizung zum beidseitigen Beheizen eines Wafers.

In der Materialprozeßtechnik insbesondere in der Beschichtungstechnik sind häufig thermische Behandlungsprozesse notwendig um eine bestimmte Materialeigenschaft zu erzielen bzw. zu züchten. In der integrierten Halbleitertechnik zum Beispiel werden Substrate mit verschiedenen Lagen aus unterschiedlichem Material beschichtet, um daraus dann elektronische Schaltungen zu ätzen. In der modernen Filtertechnik als ein anderes Beispiel werden Hochleistungsfilter für Sendeeinrichtungen aus hochtemperatursupraleitendem (HTSL-) Material mit scharfen, steil abfallenden Kanten in der Durchlaßcharateristik benötigt, um bei hochausgenutzten Frequenzbändern eine gute Trennung zwischen den eng benachbarten Frequenzkanälen zu erreichen.

Solche z.B. mit Hochtemperatursupraleiter(HTSL)-Material beidseitig zu beschichtenden Substrate durchlaufen Prozeßräume, in denen die für die Beschichtung notwendigen Umgebungsbedingungen eingestellt werden können. Die Temperatur der zu beschichtenden Fläche oder der aufgebrachten Schicht spielt dabei eine entscheidende Rolle. Je besser die Temperaturhomogenität, um so besser die Qualität der Schicht.

Es gibt Beschichtungsanlagen mit Heizeinrichtungen, bei denen das für den Prozeß notwendige Volumen völlig umschlossen ist, um eine homogene Temperaturverteilung im umschlossenen Volumen, dem Strahlungshohlraum, herzustellen. Für den Beschichtungsprozeß bedeutet das eine umständliche Handhabung durch Öffnen und Schließen des Volumens zur Beschickung und Entnahme des Wafers.

Der Erfindung liegt die Aufgabe zugrunde, in einer Beschichtungsanlage mit ein- oder vielkammerigem Prozeßraum mindestens einen Strahlungshohlraum einzurichten, in dem ein Substrat/Wafer zur gezielten Aufwärmung seiner Oberflächen und zur gleichzeitig beidseitigen Beschichtung exponiert und der Wafer verschiedenen Prozessen ohne Entnahme ausgesetzt werden kann.

Die Aufgabe wird durch eine Substratheizung, die gemäß den Merkmalen des Anspruch 1 aufgebaut ist, gelöst.

Die Substratheizung besteht aus zwei gleichartigen, wannenförmigen Heizeinrichtungen oder Heizschalen, die einander spiegelbildlich zur Transportebene des zu prozessierenden Wafers unter Aufrechterhaltung eines für den Transport notwendigen Spaltes unter Bildung eines Hohlraumes, des Strahlungshohlraumes, gegenüber stehen. Durch die Lage der beiden Heizeinrichtungen zueinander, die einen Spalt für den Transport frei lassen, wird ein hinreichend guter Strahlungshohlraum gebildet.

Die Heizeinrichtung besteht aus dem zur Wanne gebogenen Heizblech aus elektrischem Widerstandsmaterial, dessen beide Stirnseiten vom Boden unter Bildung einer ausgeprägten Viertelkreisrundung ausgehen und in Richtung der Transportebene des durchlaufenden Wafers weisen. Die beiden Stirnseiten sind über je eine Lochreihe an ihrer freien Kante an der jeweiligen Heizblechhalterung, einem Rahmen, an der zugehörigen Stromzuführung angeschlossen. Die beiden Seitenwände der Heizeinrichtung sind mit den freien Enden elektrisch isoliert, um den jeweiligen Rahmen gezogen und daran über die jeweilige Lochreihe mittels Lochleiste angeschraubt. Durch das Verschrauben des Heizblechs an den beiden Rahmen wird einerseits die Wannenform und andrerseits die elektrische Kontaktierung an den beiden Stromzuführungen erreicht.

Nach außen hin wird das wannenförmige Heizblech von der Isolationswanne ummantelt. Auf beiden Stirnseiten zwischen der Isolationswanne und dem Heizblech ragen die beiden Stromzuführungen durch den Boden der Isolationswanne hindurch. An dem jeweilig freien Ende der beiden Stromzuführungen sind die beiden Rahmen über Bügel angeschraubt.

Der Boden des Heizblechs wird zum Boden der Isolationswanne über zwei Haltestangen in Position gehalten. Die Haltestangen liegen auf dem Boden des Heizblechs und dringen am Fuß der beiden Stirnseiten durch die Wand. Sie gehen weiter und werden in Ausschnitten am Boden der beiden Rahmen in Position gehalten. Durch das Anschrauben an die beiden Stromzuführungen und das Auflegen an der Öffnung der Zylinderkathode wird die so gebildete Heizschale in Position gehalten verankert und ist elektrisch angeschlossen.

Im Boden der wannenförmigen Heizeinrichtung ist sowohl im Heizblech als auch in der Isolationswanne ein kreisrunder Durchbruch, durch den hindurch der Materialstrom von der anliegenden Zylinderkathode kommt. Um Überhitzung am Rande des zentralen kreisförmigen Durchbruchs im Heizblech zu vermeiden, ist dort beidseitig ein das Material verstärkender Ring aus ebenfalls elektrischem Widerstandsmaterial angebracht, der die um den Durchbruch verlaufenden inhomogenen Stromlinien, die Stromliniendichte berücksichtigend, derart überdeckt, daß keine lokale Überwärmung auftreten kann.

Eine saubere, an die Stromlinien- und Potentiallinienverhältnisse zwischen den beiden Lochreihen angepaßte Kontour der Ringe ist, wenn die kreisförmige Innenkontour der Staulinie des Stromlinienverlaufs zwischen beiden Lochreihen zumindest für den kreisförmigen Anteil des Durchbruchs folgt. Die Stromliniendichte ist an beiden Äquatorpunkten des Durchbruchs - so gesehen, wenn die beiden geraden Anteile der Staulinie auf der Pollinie liegen - am höchsten, dort werden sie, vom homogen Verlauf ohne Durchbruch durch diesen am stärksten zur Seite verdrängt. Dort muß dann bei den beiden Ringen die Dicke am stärksten und der äußere Durchmesser der beiden Ringe am größten sein. Die Ringe sollten, daran gemessen, den inhomogenen Stromlinienbereich bis nahezu hin zum wieder homogenen Verlauf überdecken und dort am dicksten sein, wo die Stromliniendichte am höchsten ist (Anspruch 6). Da das herstellungstechnisch einen großen Aufwand bedeutet und nur rechnergestützt hergestellt werden kann - zumindest eine Basisform davon - , ist eine grobe Näherung in Form der Außenkontour als Oval oder Ellipse ein Lösungskompromiß. Die Innenkontour bleibt der Kreis des Durchbruchs, an den beiden Polstellen ist der Außendurchmesser am kleinsten, an den beiden Äquatorpunkten ist er am größten. Vom Innendurchmesser aus nimmt die Materialstärke nach außen hin ab, z. B. linear (Anspruch 7). Lösungen zwischen der sauberen und der groben Annäherung sind je nach Anforderung in Betracht zu ziehen.

In den Unteransprüchen 2 bis 5 sind jeweils Merkmale aufgeführt, die die Wirkungsweise erleichtern. So ist die Oberfläche des Innenbodens und der Innenwand der Isolationswanne zur diffusen Streuung der auftreffenden Wärmestrahlung materialeigen mattiert, z.B. durch Sandstrahlen. Damit wird der Wärmedurchgang reduziert (Anspruch 2).

Der Wandbereich des Prozeßraums, durch den hindurch die beiden Stromzuführungen gehen, ist ein abnehmbarer Flanschdeckel. Dadurch kann eine Heizungshälfte einfach komplett abgenommen werden und ist dann Manipulationen frei und bequem zugänglich (Anspruch 3).

Bei der beträchtlichen Wärmeerzeugung besteht durch den Aufbau auch eine unvermeidliche Wärmeleitung durch die unmittelbar zusammenhängenden metallischen Bauteile. Durch einen Kühlmittelkreislauf, der bis in das Ende der beiden Stromzuführungen geführt werden kann, wird an der Übergangsstelle Stromzuführung-Heizblechkontaktierung gezielt Wärme abgeleitet (Anspruch 4).

Durch einen weiteren Reflexionsschirm und Isolationsschirm mit entsprechenden Durchbrüchen wie bei dem grundsätzlichen Aufbau um das Äußere der jeweiligen Heizschale kann die Abstrahlung nach außen hin weiter reduziert werden (Anspruch 5). Dadurch kann die Wärmeabstrahlung soweit zurückgehalten werden, daß die Anlage selbst nach außen hin nicht mehr zusätzlich wärmeisoliert werden muß. Es besteht bei Berührung der Anlagenaußenwand erst recht keine Verbrennungsgefahr mehr.

Mit der derartig aufgebauten Substratheizung wird ein hinreichender Strahlungshohlraum gebildet, in dem ein zu prozessierendes Substrat einer Umgebung mit homogener Temperaturverteilung ausgesetzt werden kann. Damit kann einerseits der Wafer beidseitig simultan beschichtet werden und andrerseits sind Bedingungen für die auf dem Substrat abzulegende Schicht geschaffen, die eine geforderte Strukturausbildung zulassen . Die Substratheizung kann in verschiedenen Kammern des Prozeßraums über Flanschdeckel leicht positionsgerecht eingebaut werden, so daß verschiedene Prozeßschritte an unterschiedlichen Kammern ohne Öffnen des Prozeßraums ablaufen können. Das ist ein industrielles Produktionsverfahren.

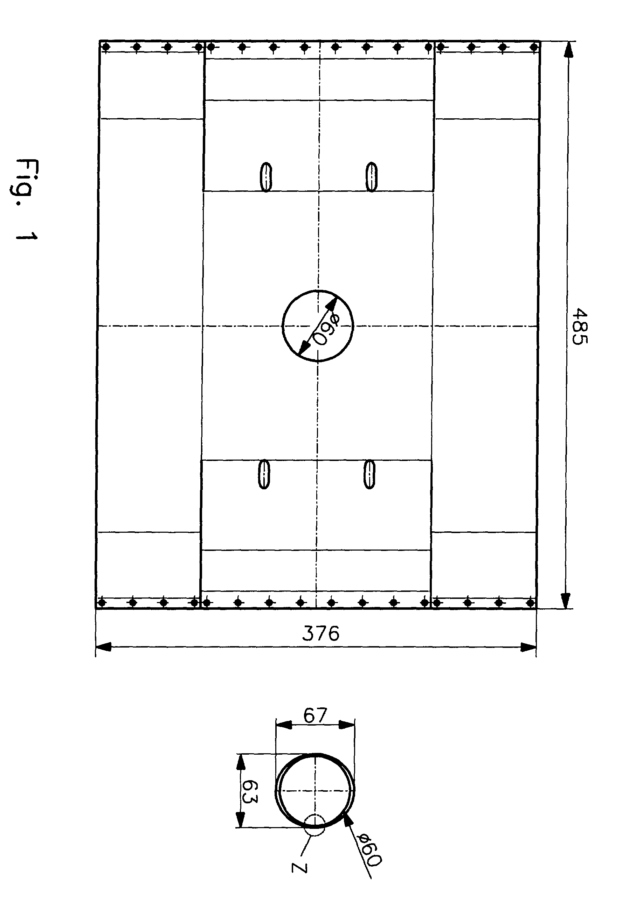

Die Erfindung wird im folgenden anhand der Zeichnung näher beschrieben. Die Zeichnung besteht aus den Figuren 1 bis ?. Sie zeigen:
- Figur 1: das in die Ebene geklappte Heizungsblech,
- Figur 2: die in die Ebene geklappte Isolationswanne,
- Figur 3: die Draufsicht auf eine Heizungseinrichtung,
- Figur 4: die Seitenansicht auf eine Heizeinrichtung,
- Figur 5: die Vakuumbeschichtungsanlage mit 4 Kammern.

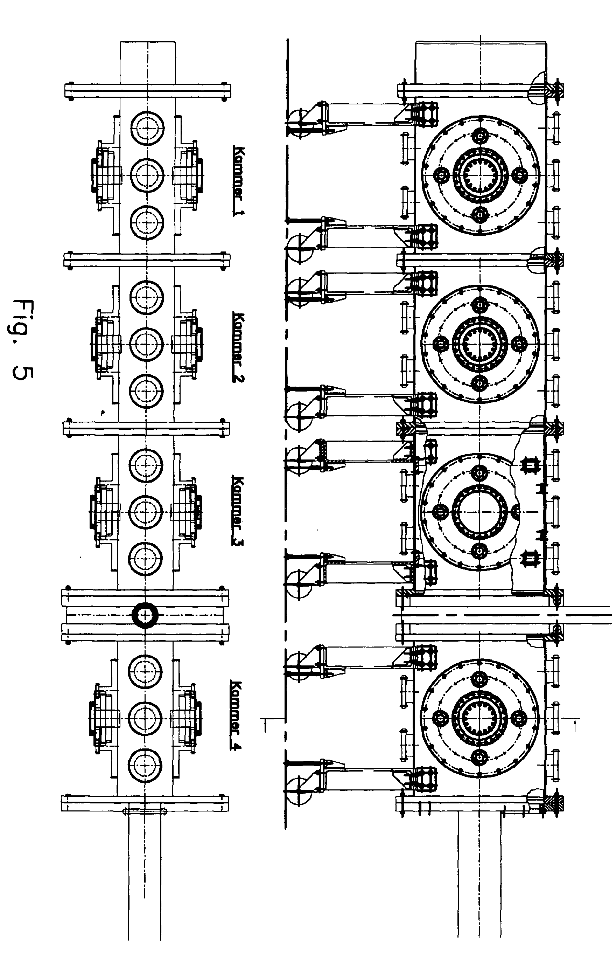

Die Substratheizung ist in der Vakuumbeschichtungsanlage "Lindwurm" (institutsinterne Bezeichnung) vorhanden, und zwar maximal in jeder der vier Kammern je eine. Eine Hälfte ist auf dem großen Flansch auf der einen Seite der Kammer und die andere auf dem gegenüberliegenden Flansch auf der andern Seite montiert (siehe Figur 5, Seitenansicht). Hinter den kleineren, zum großen Flansch konzentrischen Flanschen verbirgt sich die Sputterquelle, die in dieser Anlage eine Zylinderkathoden-Zerstäubungsquelle ist. Bei voller Bestückung einer Kammer mit zwei Zylinderkathoden sitzen dieselben auf der gemeinsamen Achse der beiden einander gegenüberliegenden Flanschanordnungen, oder gleichbedeutend, auf der Achse durch den Mittelpunkt der beiden zentralen Durchbrüche in der Substratheizung. Die jeweilige Zerstäubungsquelle erzeugt den Materialstrom auf die der Quelle zugewandten Fläche des zu beschichtenden Substrats. Die Anlage nach Figur 5 kann also maximal mit vier Heizeinrichtungen und acht Sputterquellen bestückt sein. Je nach Beschichtungsprozeß wird der Betrieb entsprechend gefahren.

Mit dieser Anlage wird der zu beschichtende Wafer an der vorgesehenen Stirnseite über Ventile in den Prozeßraum eingebracht und auf einer Transportschiene durch die Kammern gefahren, um nach dem unterbrechungslosen Beschichtungsprozeß wieder entnommen zu werden, d.h. die Anlage muß während des ganzen Beschichtungsprozesses nicht geöffnet werden. Mit der Anlage besteht eine industrielle Beschichtungseinrichtung, mit der Waferserien vielfältig, von Einfachbeschichtung bis Mehrfachbeschichtung und ein- oder beidseitig beschichtet werden können. Es können Wafer bis zu 5" Durchmesser unterbrechungslos prozessiert werden.

Der Aufbau der Substratheizung geht nacheinander aus den Figuren 1 bis 4 hervor. Von der Bemaßung her ist er beispielhaft und würde für andere Prozesse andere Dimensionen haben. Die gesamte Heizeinrichtung ist spiegelsymmetrisch aufgebaut, so daß die Beschreibung einer Hälfte den Aufbau erklärt.

Das Heizblech, die eigentliche Wärmequelle der Heizung, ist in Figur 1 in die Ebene geklappt und hat dann eine rechteckige Kontour von hier 376 mm x 485 mm. Der kreisförmige Durchbruch mit einem Radius von 30 mm um den Schnittpunkt der waagerechten mit der senkrechten Achse ist im Einbau für den Durchtritt des Materialstroms von der zugehörigen Zylinderkathode. Die beiden Langlochpaare mit dem Lochmaß 24 x 8,1 mm sind zum Durchführen der Halterohre aus Al₂O₃ für das Anlegen des Heizkörperbodens auf dem Boden der Isolationswanne.

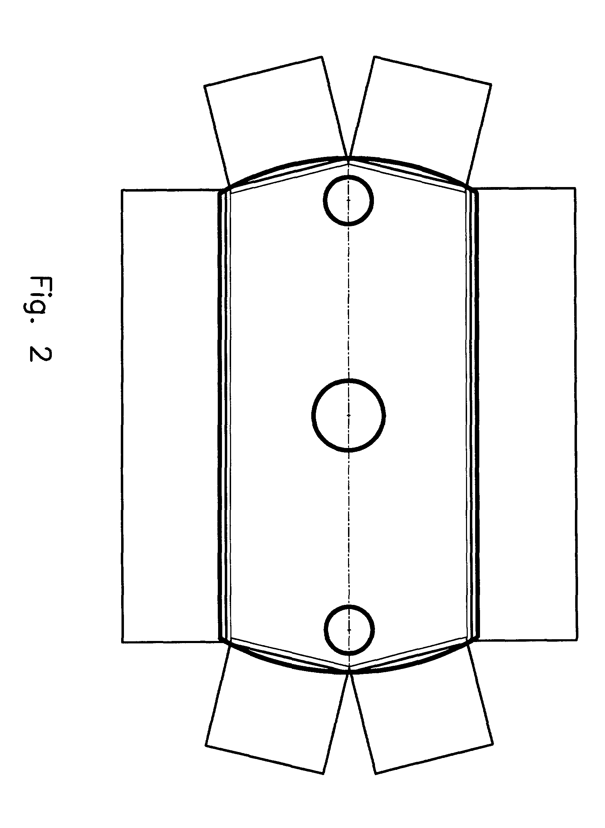

Die Isolationswanne, die in Figur 2 in in die Ebene geklappter Form dargestellt ist, ist aus Quarzglas. Sie ummantelt im Zusammenbau das Heizblech. In der Bodenmitte ist der gleichpositionierte und gleichgroße Durchbruch wie im Heizblech. Im Quarzglasboden sind noch die beiden kreisrunden Durchbrüche für die Durchführung der beiden Elektroden zum Heizblech. Die beiden Stirnseiten der Quarzglaswanne sind aus konstruktiven Gründen etwas zugespitzt. Das ist für die Montage des zur Wanne gebogenen Heizblechs an die beiden Elektroden und aus Platzgründen nützlich.

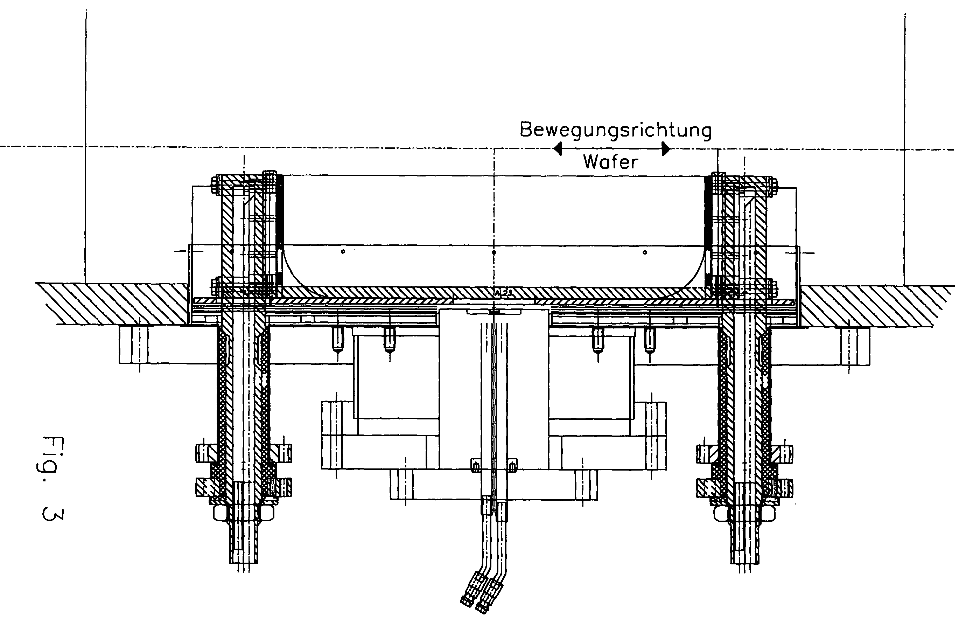

Figur 3 zeigt die eingebaute Hälfte der Substratheizung von oben. Die beiden Elektroden sind in je einem Isolierrohr geführt und darüber in dem großen Flansch, der an der Kammerwand anliegt, positioniert. Sie haben einen Zu- und Abflußkanal, so daß sie auch an einen Kühlkreislauf anschließbar sind. Durch den Boden der Isolationswanne hindurch ragen die beiden blanken Elektroden, an deren Endbereich jeweils der Rahmen, die Heizblechhalterung, über je zwei Bügel verschraubt und zusammen mit der Isolationswanne positioniert ist.

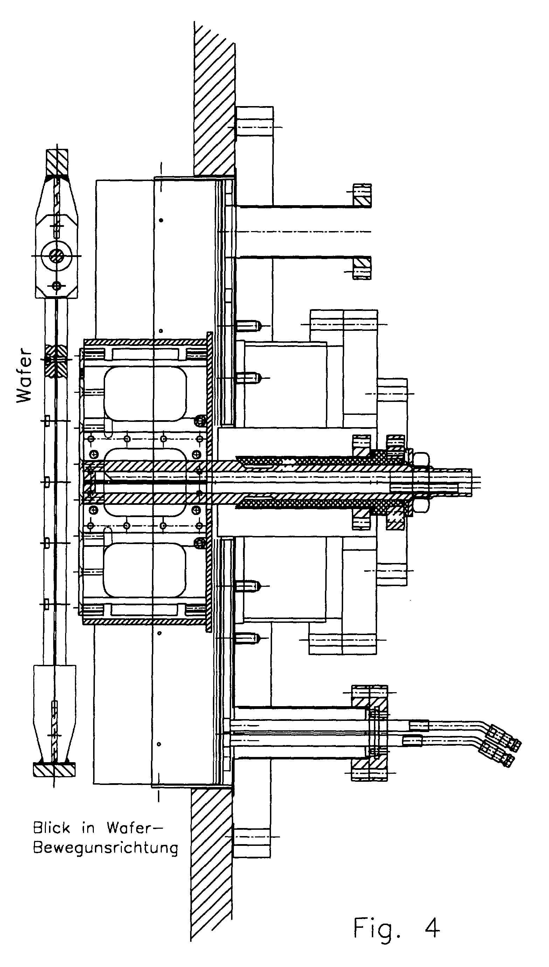

In der Seitenansicht von Figur 4 ist die Form des Rahmens, der Heizblechhalterung, besser zu erkennen. Er hat eine Doppelfunktion, nämlich: einerseits Halterung und Formstabilisierung für die komplette Heizwanne und andrerseits elektrischer Anschluß an die Elektrode. Die Wärmequelle, das Widerstandsblech oder das Glühblech, hier aus 0,05 mm dickem Alloy 600, dehnt sich über die lichte Breite der Isolationswanne aus. Zu der Achse der Stromzuführung sind an dem Rahmen zwei parallele, spiegelbildliche Reihen aus vier Gewindelöchern, an die über je eine Edelstahllochleiste die beiden äußeren Bereiche einer Lochreihe am um die abgerundete und elektrisch isolierte Kante der Heizblechhalterung gezogenen Heizblech elektrisch leitend befestigt werden. An der zur Transportbahn des Wafers weisenden Stirn der Heizblechhalterung ist ebenfalls senkrecht dazu eine Gewindelochreihe, an der ebenfalls über eine Edelstahllochleiste der innere Bereich der Lochreihe am vor der Elektrode hochgezogenen Heizblech befestigt wird. Durch diese Verschraubung an beiden Elektroden wird die Wannenform des Heizblechs erzeugt. So werden einerseits die Seitenwände und andrerseits die vom Boden her stark abgerundeten Stirnwände (siehe Figur 3) der Heizblechwanne gebildet.

Im Boden des Glühblechs ist der zentrale Durchbruch von 60 mm Durchmesser, der beidseitig mit je einem Blechring beschlagen ist, dessen äußerer größerer Durchmesser 67 mm und äußerer kleinerer Durchmesser 63 mm beträgt (siehe Figur 1 rechtes Detail). Der innere Durchmesser ist gleich dem des Durchbruchs, nämlich 60 mm.

Durch die Kontaktierung des Glühblechs über seine beiden Lochreihen entsteht im Blech selber ein homogen verteilter Strom von einer Lochreihe zur andern, d.h. es besteht eine konstante Stromdichte übers Blech verteilt. Allerdings trifft das für die nahe Umgebung des zentralen Durchbruchs nicht mehr zu, dort werden die Stromlinien zur jeweiligen lochfreien Seitenkante des Glühblechs hin wie beim laminaren Umströmen einer Kugel durch eine Flüssigkeit oder einer Kreisscheibe durch ein Flüssigkeitsband komprimiert. D.h. die Stromdichte ist im Bereich der Querachse im Durchbruchrandbereich höher, damit wird dort stärker erwärmt. Dies könnte durch eine vom Stromliniendichteverlauf abhängige Materialverdickung in den beiden Bereichen kompensiert werden, wäre aber herstellungstechnisch erheblich aufwendig. Durch eine aus dieser Sicht grobförmige Materialanreicherung in Form von zwei gleichen Ringen, die beidseitig den Durchbruchrand begrenzen, kann in diesen beiden Gebieten das auch näherungsweise kompensiert werden. Die Querschnittsverstärkung oder -erhöhung darf aber nicht zu stark ausfallen, da dann eine Stromlinienkonzentration mit lokal stärkerer Erwärmung bewirkt wird. Wenn die Masse der beiden Ringe etwa gleich der Masse des ausgestanzten Durchbruchstücks ist, wird der Erwärmungsausgleich prozeßtauglich erreicht, der mit abnehmender Masse der beiden Ringe abnimmt und mit zunehmender Masse durch verstärkte Stromlinienkonzentration für lokale Überhitzung und damit im schlechten Fall für lokales Durchschmelzen sorgt, bzw. die für den Beschichtungsprozeß notwendige homogene Temperaturverteilung nicht ergibt.

Die Stromlinienverdrängung durch die beiden Langlochpaare ist unerheblich, sie sind zudem auch nicht dem Materialstrom ausgesetzt. Wohl könnten auch sie am Rand materialverstärkt werden, was aber ein zusätzlicher, unnötiger Herstellungsaufwand wäre.

Die beiden Einschnittpaare in Stromlinienrichtung haben durch eben diese parallele Richtung keinen Einfluß auf den Stromlinienverlauf. Deshalb stehen die Wände des Glühblechs und der Isolationswanne auch senkrecht zum Boden. Bei schrägen Schnitten würden die Stromlinien im Glühblechbereich gezwungenermaßen nicht mehr homogen verlaufen, sie müßten dem Einschnitt ausweichen, was in Grenzen tolerabel wäre und am Schnittende im Blech eventuell einseitig lokale Verdickungsmaßnahmen erfordern würde. Ein technischer Aufwand, der aus aufwendigen, unwirtschaftlichen Herstellungsgründen nur wohlbegründet in Betracht käme.

## Patentansprüche

1. Substratheizung zum beidseitigen Beheizen eines Wafers in einem von der Umgebung abgeschotteten Prozeßraum, bestehend aus zwei gleichartigen, wannenförmigen Heizeinrichtungen, die spiegelbildlich zueinander stehen und so einen Heizraum, weitestgehend einen Strahlungshohlraum, bilden, wobei die beiden Heizeinrichtungen soweit auseinander stehen, dass der auf einer Transporteinrichtung sitzende, zu prozessierende Wafer gerade hochkant hindurch gezogen werden kann, und die Heizeinrichtung folgendermaßen aufgebaut ist:
der wannenförmige Heizkörper aus elektrischem Widerstandsblech bildet, in die Ebene auseinander geklappt, ein zusammenhängendes Blechstück rechteckiger Kontur mit je einer Lochreihe an zwei einander gegenüberliegenden Kanten, von jeder dieser Kanten gehen jeweils zwei gleich lange Einschnitte, ein Einschnittpaar, senkrecht und in vorgegebenem Abstand zueinander sowie zu den andern beiden Rechteckkanten ins Blechinnere, die sich in vorgegebenen Abstand unter Bildung einer zentralen einschnittsfreien Zone, dem Bodenbereich, ebenfalls spiegelbildlich gegenüber liegen,
im Zentrum des Bodenbereichs ist ein kreisförmiger Durchbruch vorgegebenen Durchmessers, der auf beiden Bodenseiten je von einem Blechring variierenden Außendurchmessers berandet ist, und zwar ist der Außendurchmesser auf der Längsachse des Bodenbereichs durch den Durchbruchmittelpunkt am kleinsten und
wächst zur dazu senkrechten Querachse hin kontinuierlich an, am Fuße der beiden stirnseitigen Bewandungen sind jeweils zwei langlochartige Durchbrüche,
das wannenförmig gehaltene Widerstandsblech liegt in einer Isolationswanne aus thermisch hochbeständigem, dielektrischem Material, in deren Boden sich neben dem zentralen Durchbruch mit demselben Durchmesser wie im Widerstandsblech am Rande des stirnseitigen Bodenbereichs zwei weitere Durchbrüche im Blechstück befinden, die bezüglich der Querachse spiegelbildlich zueinander und außerhalb der Wanne aus dem Widerstandsblech liegen, und
zwei für die thermische Beanspruchung geeignete, formbeständige Stangen aus dielektrischem Material zur Positionierung des Heizblechs durch die beiden Langlochpaare derartig geschoben sind, dass der Bodenbereich des wannenförmigen Heizkörpers zwischen diesen und dem Boden der Isolationswanne liegt,
jede Stirnseite des wannenförmigen Widerstandsblech und die beiden an derselben hinausragenden Enden der Seitenwände sind über Lochleisten an je einen metallischen Rahmen geschraubt, die beiden Stangen sind am Fuße der beiden Rahmen eingelegt und
die derart gebildete wannenförmige Hälfte der Heizeinrichtung ist über Bügel an den beiden Rahmen an zwei durch die beiden Durchbrüche im Boden der Isolationswanne ragenden Stromzuführungen verschraubt und dadurch gleichzeitig positioniert und verankert.

2. Substratheizung nach Anspruch 1,
**dadurch gekennzeichnet, dass**
die Oberfläche des Innenbodens und der Innenwand der Isolationswanne zur Streuung der Wärmestrahlung materialeigen mattiert sind.

3. Substratheizung nach Anspruch 2,
**dadurch gekennzeichnet, dass**
der Wandbereich des Prozeßraums, durch den hindurch die beiden Stromzuführungen führen, ein abnehmbarer Flanschdeckel ist.

4. Substratheizung nach Anspruch 3,
**dadurch gekennzeichnet, dass**
die Stromzuführungen bis hin zu dem jeweiligen Rahmen Bestandteil eines Kühlmittelkreislaufs sind.

5. Substratheizung nach Anspruch 4,
**dadurch gekennzeichnet, dass**
die beiden Heizschalen selbst noch von einer weiteren Reflexions- und Isolationsschale ummantelt sind.

6. Substratheizung nach Anspruch 5,
**dadurch gekennzeichnet, dass**
die beiden Blechringe, die den zentralen Durchbruch im Boden des wannenförmigen Heizblechs auf beiden Seiten beranden, den Bereich des durch den Durchbruch in der dortigen Umgebung erzwungenen inhomogenen Stromlinienverlaufs bis höchstens hin zum wieder als homogen anzusehenden Stromlinienverlauf zwischen den beiden Lochreihen, entsprechend der Stromliniendichte dick, überdecken.

7. Substratheizung nach Anspruch 5,
**dadurch gekennzeichnet, dass**
die beiden Blechringe, die den zentralen Durchbruch im Boden des wannenförmigen Heizblechs auf beiden Seiten beranden, den Bereich des durch den Durchbruch in der dortigen Umgebung erzwungenen inhomogenen Stromlinienverlaufs teilweise überdecken und die äußere Kontour der beiden Ringe oval oder ellipsenförmig ist.
